(19) **Europäisches Patentamt / European Patent Office / Office européen des brevets**

(11) **EP 4 764 511 A1**

(12) # EUROPEAN PATENT APPLICATION

(43) Date of publication:
**24.06.2026 Bulletin 2026/26**

(21) Application number: **24220622.5**

(22) Date of filing: **17.12.2024**

(51) International Patent Classification (IPC):
**G01R 27/32** (2006.01)    **G01R 35/00** (2006.01)

(52) Cooperative Patent Classification (CPC):
**G01R 27/32; G01R 35/005;** G01R 27/28;
G01R 29/26

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Nederlandse Organisatie voor toegepast-natuurwetenschappelijk onderzoek TNO 2595 DA 's-Gravenhage (NL)**

(72) Inventors:
• **Kroll, James Grant**
  **2595 DA 's-Gravenhage (NL)**
• **Eendebak, Pieter Thijs**
  **2595 DA 's-Gravenhage (NL)**

(74) Representative: **V.O.**
  **P.O. Box 87930**
  **2508 DH Den Haag (NL)**

(54) **ARRANGEMENT AND METHOD FOR CHARACTERIZING A RADIO FREQUENCY DEVICE AND STORAGE DEVICE**

(57)    An arrangement for characterizing a radio frequency (RF) device, DUT, is provided using a calibrated noise source, CNS (20), a vector network analyzer (10, VNA), a spectrum analyzer (10, SA), a switching assembly (300, 50) and a processing unit (60) configured to control the switching assembly (300, 50) and to estimate the characteristics of the RF device based on measurements performed by the VNA. In some embodiments the arrangement estimates S-parameters of the noise path from a computation using S-parameters of a signal path comprising in addition to the noise-path a further component and the inverted S-parameters of that component.

FIG. 2

**Description**

BACKGROUND

The present invention pertains to an arrangement for characterizing a radio frequency (RF) device.

The present invention further pertains to a method for characterizing an RF device.

The present invention still further pertains to a non-transitory computer-readable storage device storing a program configured to instruct a programmable device to perform the method.

For many applications it is of utmost importance to accurately know the electrical properties of components. A particular example is in the field of quantum computing which requires technology suitable to amplify extremely weak microwave signals. This is only possible if the properties of the signal processing components are accurately determined. A known method is disclosed by Simbierowicz et al in "Characterizing cryogenic amplifiers with a matched temperature-variable noise source", Review of Scientific Instruments, 92(3), 034708. https://doi.org/10.1063/5.0028951. Whereas this method renders it possible to determine the noise temperature of the RF device, it is not possible therewith to simultaneously estimate its S-parameters.

SUMMARY

It is a first object of the present invention to provide an improved arrangement for characterizing an RF device, in particular a cryogenic amplifier, including the estimation of its S-parameters.

It is a second object of the present invention to provide an improved method for characterizing an RF device, in particular a cryogenic amplifier, including the estimation of its S-parameters.

It is a third object of the present invention to provide a non-transitory computer-readable storage device storing a program configured to instruct a programmable device to perform the improved method.

An improved arrangement according to the first object is specified in claim 1. As specified therein, the arrangement for characterizing a radio frequency (RF) device, also denoted herein as DUT, comprises a calibrated noise source, a vector network analyzer, a spectrum analyzer, a switching assembly and a processing unit.

The calibrated noise source, also denoted as CNS is provided for generating a controlled noise signal. For room temperature measurements, semiconducting avalanche diodes are suitable, as well defined and accurate models are available to predict their power output characteristics. At cryogenic temperatures however, the behavior of avalanche diodes is not accurately predictable, but other suitable noise sources are available, such as a temperature based Johnson-Nyquist noise sources or shot noise tunnel junctions. In another arrangement a measured quantum efficiency is used as a means to characterize electronic circuitry.

The vector network analyzer is configured to output a signal and measure the amplitude and phase of the transmitted and reflected signal versus frequency within a frequency range. The vector network analyzer and the spectrum analyzer are usually separate devices, but in some cases the vector network analyzer and the spectrum analyzer may be integrated in a vector network analyzer/spectrum analyzer unit.

The switching assembly serves to controllably arrange mutually different signal paths to be measured by the VNA. The switching assembly comprises at least an input switch unit and an output switch unit. The input switch unit has an input side that defines an input calibration plane and that has multiple inputs. One of these inputs is connected to the CNS. One or more other inputs are connected to respective calibration components having known S parameters.

The calibration components are mutually different and may comprise at least three mutually different calibration components selected from a Short component, an Open component, a Load component, a Thru component a Reflect component and a Lambda/4 resonator.

In summary, the Short component is a short circuit that directly connects the RF signal to ground. Hence ideally, its impedance Z = 0, its reflection coefficient Γ = -1 (100%, inverted phase). The voltage standing wave ratio (VSWR) is Infinite.

The Open component is an open circuit, where the RF signal is left unconnected. Hence ideally, its impedance Z is infinite. Its reflection coefficient Γ = 1, implying 100% reflection without phase inversion. The voltage standing wave ratio (VSWR) is infinite.

The Load component is a resistive or complex impedance component representing a termination. Hence its impedance Z = R + jX (resistive and reactive components). The reflection coefficient of the Load component depends on the load impedance relative to the characteristic impedance as follows:

$$\Gamma = \frac{Z - Z_0}{Z + Z_0}$$

A perfect matching occurs when $Z = Z_0$

The Thru component provides a direct connection between input and output with minimal insertion loss. For that purpose, its impedance matches the characteristic impedance $Z_0$ and ideally its reflection coefficient $\Gamma = 0$ and its transmission coefficient $S_{21} = 1$ or 0 dB. The phase shift ideally is 0°.

The Reflect component is a component or condition that reflects the signal back to the source. The impedance of the Reflect component often varies, and could be matched or mismatched relative to $Z_0$. The reflection coefficient $\Gamma$ ranges from 0 to 1, depending on the mismatch and the phase shift depends on the reactive part of the impedance.

The Lambda/4 resonator is a quarter-wavelength resonator, a segment of transmission line with a physical length equal to Lambda/4 at the operating frequency. The Lambda/4 resonator acts as an impedance inverter, in that it converts a short circuit at one end to an open circuit at the other, and vice versa. The impedance transformation in the Lambda/4 resonator is specified as:

$$Z_{in} = \frac{Z_0^2}{Z_{load}}$$

These components, when used appropriately, help in designing and analyzing RF circuits for optimal performance.

In an example the calibration components comprise a LOAD, an OPEN and a SHORT component.

The input switch unit further has an output side with multiple outputs comprising a first output, a second output and further outputs connected to respective calibration components having known S-parameters. The output side of the input switch unit defines an intermediate calibration plane.

The output switch unit has an input side that defines an output calibration plane and that has multiple inputs. At an output side the output switch unit has an output coupled to the VNA.

The arrangement comprises a first partial signal path between a first output of the input switch unit and a first input of the output switch unit, and a second partial signal path between a second output of the input switch unit and a second input of the output switch unit. The first signal path comprises a cascade of a thru connection, THRU and the DUT. The second signal path only comprises a thru connection THRU.

The output switch unit has one or more further inputs connected to one or more respective calibration components with known parameters. In an example the calibration components comprise a LOAD, an OPEN and a SHORT component.

It is noted that a calibration may alternatively be performed with another set of mutually different calibration components. In one example thereof the mutually different calibration components comprise a Thru, a Reflect and a Line component.

The processing unit is configured to control the switching assembly to controllably arrange mutually different signal paths to be measured by the VNA, and to estimate the characteristics of the RF device based on measurements performed by the VNA. The estimation may be performed in a first and a second operational stage. In the first operational stage the processing unit is configured to control the switching assembly to perform calibrations so as to estimate S-parameters of an input noise signal path from the noise source to the DUT. In the second operational stage the processing unit is configured to control the switching assembly to arrange a noise measurement signal path including the input noise signal path, the DUT and an output noise signal path from the DUT to an input of the spectrum analyzer SA.

In the first operational stage the processing unit may perform a two-port de-embedding on the intermediate plane and the output plane by performing first SOLT-measurements wherein the input switch unit is coupled at its input side to the first VNA port and the output switch unit is coupled at its output to the second VNA port. The processing unit may then simultaneously control the outputs of the input switch unit and the inputs of the output switch unit to subsequently select each of the first partial signal path and the SOLT calibration standards including the thru connection in the second partial signal path. With the measurement results obtained by the VNA for these switch configurations de-embedding results can be computed that comprise S-parameters of the first partial signal path, S-parameters of the second partial signal path, S-parameters of a signal path from the first VNA-port to the intermediate plane and S-parameters of a signal path from the second VNA-port to the output plane. It will be clear to those skilled in the art that these measurements can be performed in arbitrary order.

In the first operational stage the processing unit may further perform a two-port de-embedding on the intermediate plane and the input plane, by performing second SOLT calibration measurements for the input plane with the input switch unit and the output switch unit being coupled via the second partial signal path and the output switch unit coupled to the second VNA port and further performing third SOLT calibration measurements for the intermediate plane with the input switch unit coupled to the first VNA port. Also these measurements may be performed in arbitrary order, e.g. performing the third SOLT calibration measurements subsequent to the second SOLT calibration measurements or reversely, or performing first the thru measurement for each of the second and the third SOLT calibration measurements then the short measurements for bot, etc.

The processing unit may then use the second and the third SOLT calibration measurement results to compute de-embedding results comprising S-parameters of each of the path between the intermediate calibration plane and the input calibration plane, of the signal path from the first VNA port to the intermediate calibration plane and of the signal path from the second VNA port to the input calibration plane.

It is noted that for performing the noise response measurements in the second operational stage, the S-parameters of the path from the input calibration plane to the intermediate calibration plane need to be estimated. However the de-embedding using the second and the third SOLT calibration measurements results in the S-parameters of the path from the intermediate calibration plane to the input calibration plane, which represent in fact a path of negative length. According to the present invention the proper S-parameters are estimated as follows.

The estimated S-parameters of the path from the intermediate calibration plane to the input calibration plane are converted to a transfer matrix and the transfer matrix is inverted and the inverse transfer matrix is converted to S-parameters as an estimation of the S-parameters of the path from the input calibration plane to the intermediate calibration plane.

Now, as a final step of the first operational stage the S-parameters of the signal path from the noise source to the DUT may be computed by composition of the S-parameters of the connection extending from the noise source to the input calibration plane, the S-parameters of the path from the input calibration plane and the intermediate calibration plane and the S-parameters of the connection extending from the intermediate calibration plane to the DUT.

In the second operational stage the processing unit cause the switching assembly to receive the controlled noise signal and to select the first partial signal path. The estimated two port S parameters of the path from the controlled noise source to the DUT enable the processing unit to estimate a loss incurred by the controlled noise signal resulting in an attenuated noise signal received at the input of the DUT. In the second operational stage the SA measures the output of the output switch unit and the processing unit estimates the noise performance of the DUT from the measured output and the estimated attenuated noise signal.

It is presumed that the two-port S-parameters of the signal path between the input calibration plane and the input to the DUT are the same as those estimated for the signal path between the input calibration plane and the output calibration plane, as the THRU between the input switch unit and the input of the DUT and the THRU between the input switch unit and the input of the output switch unit are specimen of a same calibrated type of component.

In an embodiment the processing unit is configured to control the controlled noise source to generate a noise signal corresponding to a temperature that is varied in a temperature range and to perform a Y-factor computation based on the measurement results obtained for the temperature range.

In the above it was assumed that the input switch unit is a single multiple input to multiple output switch. Whereas this is theoretically possible, for cryogenic calibration tasks it has been found favorable that the input switch unit comprises an N to 1 switch and a 1 to N switch.

Also for cryogenic calibration tasks, it is favorable if the controllable noise source is coupled to the input switch unit, or in the preferred case to the input switch of the input switch unit via a further THRU connection. Therewith a better thermal insulation is obtained between the CNS and the DUT. This is particularly advantageous if the CNS is operated at different temperatures. In an embodiment the additional THRU that couples the noise source to the input switch unit is a superconducting connection. Superconducting materials generally have a lower thermal conductivity in the superconducting state as compared to their normal state, which further contributes to thermally decoupling the noise source from the DUT.

BRIEF DESCRIPTION OF THE DRAWINGS

These and other aspects are described in more detail with reference to the drawings. Therein:

FIG. 1 schematically shows a first embodiment of an arrangement for characterizing a device under test DUT,
FIG. 2 schematically shows an embodiment of a method for characterizing a device under test DUT,
FIG. 3 schematically shows a second embodiment of an arrangement for characterizing a device under test DUT.

DETAILED DESCRIPTION OF EMBODIMENTS

Like reference symbols in the various drawings indicate like elements unless otherwise indicated.

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

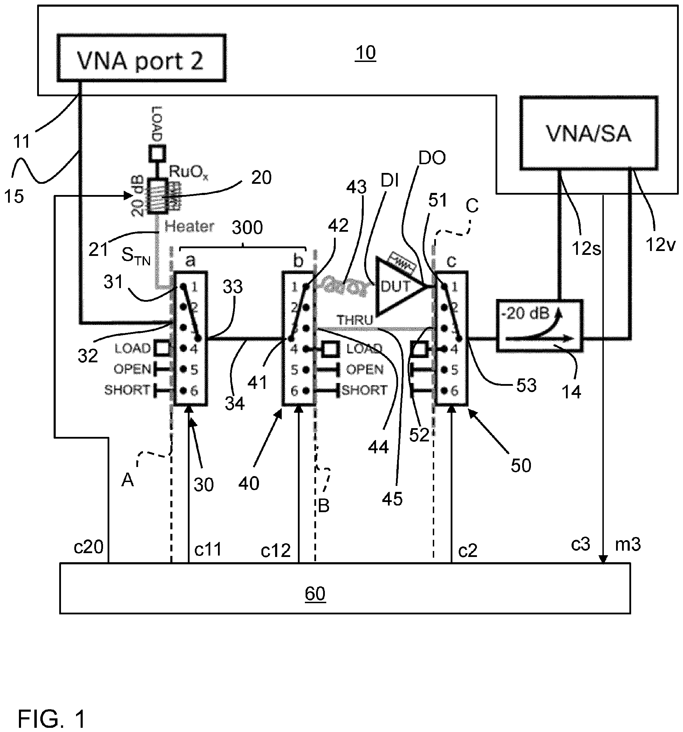

FIG. 1 schematically shows an arrangement 1 for characterizing an RF device under test DUT. As shown in FIG.

1, the arrangement comprises a calibrated noise source 20, a vector network analyzer/spectrum analyzer VNA/SA 10, a switching assembly including an input switch unit 300, an output switch unit 50. In the embodiment shown the input switch unit comprises an N to 1 switch 30 and a 1 to N switch 40. The N to 1 switch 30 is coupled at its output 33 via a thru 34 to a sole input 41 of the 1 to N switch 40. Therewith this further embodiment can be readily configured using commercially available cryogenic switches. By way of example the VNA and the SA are illustrated as if they were integrated in a single unit 10. In practice the VNA and the SA typically are separate devices and the switching assembly provides the proper electric signal connections to these devices.

The arrangement further comprises a processing unit 60.

The calibrated noise source 20, for convenience also denoted as CNS, is provided for generating a controlled noise signal. For room temperature measurements, semiconducting avalanche diodes are suitable, as well defined and accurate models are available to predict their power output characteristics. At cryogenic temperatures however, the behavior of avalanche diodes is not accurately predictable, but other suitable noise sources are available, such as a temperature based Johnson-Nyquist noise sources or shot noise tunnel junctions. In other arrangements a measured quantum efficiency is used as a means to characterize electronic circuitry. In the example shown in FIG. 1, the noise source 20 is coupled by a connection, e.g. a thru 21 to the input 31 of the switch 30. Also the additional THRUs 21 and 34 between the switches 30, 40 renders possible a better thermal insulation of the DUT from the noise source, which is advantageous if the noise-source is thermally controlled. Therewith a noise characteristic of the noise source 20 can be controlled by a temperature while mitigating effects thereof on the DUT. In an exemplary embodiment one or more of the THRUs 21 and 34 are provided as a superconducting connection. Superconducting materials generally have a lower thermal conductivity in the superconducting state as compared to their normal state, which further contributes to a thermal decoupling of the noise source from the DUT.

The vector network analyzer 10 is configured to measure amplitude and phase of an input signal versus frequency within a frequency range.

The switching assembly 300, 50 serves to controllably arrange mutually different signal paths to be measured by the VNA 10. The input switch unit 300, in this case the input switch 30 of the input switch unit, has an input side that defines an input calibration plane A and that has multiple inputs. One of these inputs 31 is connected to the CNS 20. Another one is connected to a first VNA port 11. One or more other inputs are connected to respective calibration components having known S parameters. In the example shown the calibration components comprise a LOAD, an OPEN and a SHORT component.

The output switch unit 50 has an input side that defines an output calibration plane C and that has multiple inputs. At an output side the output switch unit 50 has an output coupled to the VNA 12.

An intermediate calibration plane B is defined at the output side of the input switch unit 300, i.e. the output side of the 1 to N switch 40.

The arrangement 1 comprises a first partial signal path between a first output 42, in this case the output 42 of the 1-N switch 40 of the input switch unit 300 and a first input 51 of the output switch unit 50. The arrangement further comprises a second partial signal path between a second output 44 of the input switch unit 300 and a second input 52 of the output switch unit 50. The first partial signal path comprises a cascade of a through connection, THRU 43 and the DUT. The second partial signal path only comprises a through connection THRU 45.

The output switch unit 50 has one or more further inputs connected to one or more respective calibration components with known parameters. In the example shown, the calibration components comprise a LOAD, an OPEN and a SHORT component.

The processing unit 60 is configured to control the switching assembly 300, 50 to controllably arrange mutually different signal paths to be measured by the VNA and to estimate the characteristics of the RF device based on measurements performed by the VNA 12. To that end the processing unit 60 is configured to control the input switch unit 300 with control signals c11 and the output switch unit 50 with control signals c12. The processing unit 60 is further configured to control the VNA 12 with control signals c3 and receive measurement data m3 from the VNA.

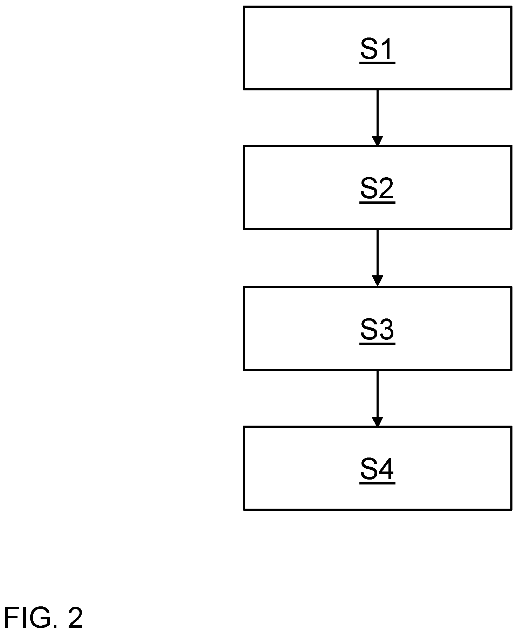

In one example as illustrated in FIG. 2, the processing unit 60 performs the following operations.

Therewith it is presumed that the respective S-parameters $S21_{21}$, $S21_{43}$ and $S21_{45}$ of the through connections, referred to as 21, 43 and 45 are equal, i.e.

$$S21_{45} = S21_{43} = S21_{21}$$

Further, for convenience, the setting of the switches 30, 40 and 50 are denoted as $M_{ijk}$, wherein i, j, k respectively indicate the port number of these switches. For example $M_{366}$ indicates that the 3rd port of switch 30 is selected and that the 6th port is selected of both switch 40 and switch 50.

In a first step S1 of this example, a 2-port SOLT de-embedding is applied on the calibration planes B and C.

To that end a series of measurements is performed with the VNA/SA with the set of switch settings $M_{BC} = \{M_{366},$

$M_{355}$, $M_{344}$, $M_{333}$, $M_{311}$}. It will be clear that the order of the switch settings is not relevant.

With the measurement results the following de-embedding results are computed.

| S | Path |
|---|---|
| $S_{thru}$ | 45 |
| $S_{dut*}$ | 43+DUT+51* |
| $S_B$ | 15 + j-<u>33</u> + 34 + 41-j |
| $S_C$ | <u>12v</u> + 14* + <u>53-j</u> |

In the above 51* represents the path section from the DUT to the corresponding input 51 of the output switch 50.

The reference 41-j represents the path section from input 41 of to the j-th output of the switch 40. Analogously j-53 denotes the path section from the output 53 to the j-th input of the output switch 50.

It is presumed that for each of the switches the S-parameters for a path section between an input and an output are the same for any selection of j.

The reference 14* denotes the amplifier 14 inclusive its connections to the second VNA port 12v and to the output 53 of the output switch 50.

In a second step S2, another 2-port SOLT de-embedding is applied on the calibration planes B and A (Note the reverse order). To that end a measurement series is performed with the VNA/SA with the set of switch settings $M_{BA}$ = {$M_{633}$, $M_{363}$, $M_{533}$, $M_{353}$, $M_{433}$, $M_{343}$, $M_{333}$}. The DUT is not involved in this measurement.

The de-embedding results obtained therewith are:

| S | Path |
|---|---|
| $S_{thruBA}$ | j-41 +<u>34</u>+33-j |
| $S_B$ | 15 + j-<u>32</u> + 34 + <u>41-j</u> |
| $S_{A,right}$ | 14*+ <u>53-i</u> + 45 + <u>j-41</u> + <u>33-j</u> |

As noted, because the calibration planes A and B are reversed (as compared to a normal SOLT), the "thru" between A and B is estimated to have a negative length. In other words, the S-parameters of this path section, which actually is an attenuator due to the inevitable resistive loss, would resemble those of an amplifier. Accordingly, in a next step S3 the estimated parameters of the thru are inverted to obtain a correct estimation. In summary the S-parameters $S_{thruAB}$ are obtained from the S-parameters $S_{thruBA}$, by a conversion of the S-parameters to transfer parameters, inverting the matrix of transfer parameters and then converting back the inverted transfer matrix to S-parameters.

More specifically, the parameters of the transfer matrix T are computed from the S-parameters as follows:

$$T_{11} = S_{12} - \frac{S_{11}S_{22}}{S_{21}}, T_{12} = \frac{S_{11}}{S_{21}}, T_{21} = -\frac{S_{22}}{S_{21}}, T_{22} = \frac{1}{S_{21}}$$

Subsequently, the matrix T is inverted to obtain $T^{-1}$.

Then the S-parameters S' of the inverted matrix T, which are the S-parameters $S_{thruAB}$ are computed as:

$$S'_{11} = \frac{T_{12}^{-1}}{T_{22}^{-1}}, S'_{21} = \frac{1}{T_{22}^{-1}}, S'_{12} = T_{11}^{-1} - \frac{T_{12}^{-1}T_{21}^{-1}}{T_{22}^{-1}}, S'_{22} = -\frac{T_{21}^{-1}}{T_{22}^{-1}}$$

Now the S-parameters $S_{NS,DUT}$ of the path from the noise source 20 to the DUT are computed by the composition of S-parameters $S_{thru}$ @ $S_{thruAB}$ @ $_{Sthru}$. Herein, the operator @ means the composition of S-parameters. For example to compute the composition of S-parameters A, B in the expression A @ B, each of the S-parameters A and B is converted to transfer matrices $T_A$ and $T_B$, respectively, the matrix product $T_A*T_B$ is computed and converted back to S-parameters again using the above-specified relationships.

In a subsequent step S4, the processing unit 60 controls the switching assembly 300, 50 so as to receive the controlled noise signal from the CNS 20 and to select the first signal path comprising the DUT. In this step S4 the processing unit 60 may further control a noise characteristic of the noise source 20 with a control signal c20. For example the processing unit 60 may control a noise temperature of a thermal noise source for the purpose of performing a Y-factor measurement.

Using the S parameters $S_{NS,DUT}$ estimated in the preceding step the processing unit 60 then estimates a loss incurred by the controlled noise signal resulting in an attenuated noise signal received at the input of the DUT. In this setting of the switching assembly the processing unit 60 estimates the noise performance of the DUT from noise measurements using the SA and the output 53 of the output switch unit 50 measured with the VNA 12 and from the estimated attenuated noise signal. Therewith the noise loss can be calculated (narrowband calculation) by selecting the $S_{21}$ value at the frequency of the noise measurement.

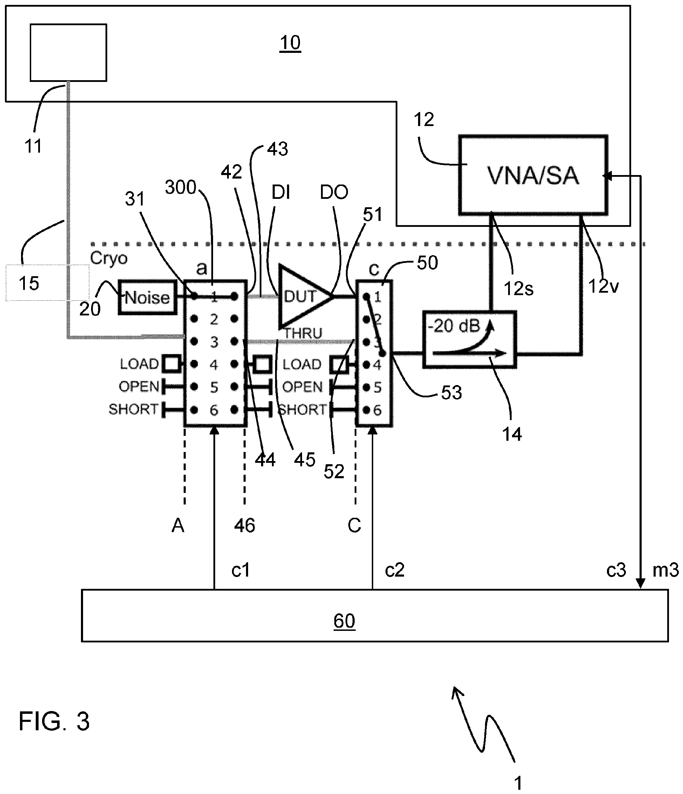

FIG. 3 shows an alternative embodiment, wherein the noise source 20 is directly coupled to an input of the input switch unit 300 and wherein the input switch unit 300 is provided as a single NxN switch. This embodiment is less advantageous, but may be useful in less critical applications.

As becomes apparent from the above, embodiments of the present invention render it possible to measure the S-parameters of the signal path between the noise source and the DUT and use these S-parameters for performing the noise measurement simultaneously, i.e. in the same measurement system and during the same cooldown procedure.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

**Claims**

1. An arrangement for characterizing a radio frequency, RF, device, DUT, comprising:

   a calibrated noise source, CNS (20), for providing a controlled noise signal;
   a vector network analyzer (10, VNA) having a first VNA port (11) and a second VNA port (12v);
   a spectrum analyzer (10, SA) having an SA port (12s);
   a switching assembly (300, 50), comprising at least an input switch unit (300) and an output switch unit (50);
   the input switch unit (300) having an input side with multiple inputs of which a first input (31) is connected to the CNS, of which a second input (32) is coupled to the first port (11) of the VNA/SA and of which one or more other inputs are connected to respective calibration components (LOAD, OPEN SHORT) having known S-parameters, the input side defining an input calibration plane (A), the input switch unit (300) further having an output side with multiple outputs comprising a first output, a second output and further outputs connected to respective calibration components (LOAD, OPEN SHORT) having known S-parameters, the output side defining an intermediate calibration plane (B);
   the output switch unit (50) having an input side, defining an output calibration plane (C) and having multiple inputs and having an output side with an output coupled to the second VNA port(12v);
   a first partial signal path between the first output (42) of the input switch unit (300) and a first input (51) of the output switch unit (50), the first partial signal path comprising a cascade of a thru connection, THRU (43) and the DUT;
   a second partial signal path between the second output (44) of the input switch unit (300) and a second input (52) of the output switch unit (50), the second partial signal path comprising a thru connection (THRU);
   the output switch unit (50) having one or more further inputs connected to one or more respective calibration components (LOAD, OPEN SHORT) having known parameters,
   a processing unit (60) configured to control the switching assembly (300, 50) for performing various calibration measurements for estimating the S-parameters ($S_{NS-DUT}$) of the signal path from the noise source to the DUT and to estimate the characteristics of the RF device based on measurements of the response of the RF device to the controlled noise signal, performed by the SA using said estimated S-parameters ($S_{NS-DUT}$).

2. The arrangement according to claim 1, configured to perform said characterizing under cryogenic circumstances.

3. The arrangement according to any of the preceding claims, wherein the input switch unit (300) comprises an N to 1 switch (30) and a 1 to N switch (40).

4. The arrangement according to any of the preceding claims, wherein the noise source (20) is coupled to the input switch unit (300) via an additional THRU (21).

5. The arrangement according to claim 4, wherein the additional THRU (21) that couples the noise source to the input switch unit is a superconducting connection.

6. A method for characterizing a radio frequency (RF) device, DUT, with the arrangement of claim 1, the method comprising

performing a two-port de-embedding on the intermediate plane (B) and the output plane (C), by performing first measurements wherein the input switch unit (300) is coupled at its input side to the first VNA port (11) and the output switch unit (50) is coupled at its output (53) to the second VNA port (12v), wherein the outputs of the input switch unit (300) and the inputs of the output switch unit (50) are simultaneously controlled to subsequently select each of the first partial signal path and the calibration standards including the thru connection in the second partial signal path and computing de-embedding results comprising S-parameters ($S_{dut*}$) of the first partial signal path, S-parameters ($S_{thru}$) of the second partial signal path, S-parameters ($S_B$) of a signal path from the first VNA-port (11) to the intermediate plane (B) and S-parameters (Sc) of a signal path from the second VNA-port (12v) to the output plane (C);

performing a two-port de-embedding on the intermediate plane (B) and the input plane (A), by performing second calibration measurements for the input plane (A) with the input switch unit (300) and the output switch unit (50) being coupled via the second partial signal path and the output switch unit (50) coupled to the second VNA port (12v) and performing third calibration measurements for the intermediate plane (B) with the input switch unit coupled to the first VNA port (11), and using the second and the third calibration measurements to compute de-embedding results comprising S-parameters ($S_{thruBA}$) of the path between the intermediate calibration plane (B) and the input calibration plane (A), S-parameters ($S_B$) of the signal path from the first VNA port (11) to the intermediate calibration plane (B) and S-parameters of the second VNA port (12v) to the input calibration plane (A);

converting the S-parameters ($S_{thruBA}$) of the path between the intermediate calibration plane (B) and the input calibration plane (A) to a transfer matrix (T);

inverting the transfer matrix (T) to obtain the inverse ($T^{-1}$) of the transfer matrix;

converting the inverse transfer matrix ($T^{-1}$) to S-parameters as an estimation of the S-parameters ($S_{thruAB}$) of the path between the input calibration plane (A) and the intermediate calibration plane (B);

computing the S-parameters ($S_{NS-DUT}$) of the signal path from the noise source to the DUT by composition of the S-parameters ($S_{thru}$) of the connection extending between the noise source and the input calibration plane (A), the S-parameters ($S_{thruAB}$) of the path between the input calibration plane (A) and the intermediate calibration plane (B) and the S-parameters ($S_{thru}$) of the connection extending between the intermediate calibration plane (B) and the DUT;

causing the switching assembly (500) to receive the controlled noise signal and to select the first partial signal path,

using the estimated two port S parameters ($S_{NS-DUT}$) to estimate a loss incurred by the controlled noise signal resulting in an attenuated noise signal received at the input of the DUT,

with the SA (12s) measuring the output of the output switch unit (50) and estimating the noise performance of the DUT from the measured output and the estimated attenuated noise signal.

7. The method according to claim 6, wherein the mutually different calibration components comprise at least three mutually different calibration components selected from a Short component, an Open component, a Load component, a Thru component a Reflect component and a Lambda/4 resonator.

8. The method according to claim 7, wherein the mutually different calibration components comprise a Short, Open and a Load component.

9. The method according to claim 7, wherein the mutually different calibration components comprise a Thru, a Rflect and a Line component.

10. A non-transitory computer-readable storage device storing a program configured to instruct a programmable device to perform the steps of claim 7, 8 or 9.

FIG. 1

S1

S2

S3

S4

FIG. 2

FIG. 3

Europäisches
Patentamt

European
Patent Office

Office européen
des brevets

# EUROPEAN SEARCH REPORT

**Application Number**

EP 24 22 0622

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BRANDON BOIKO ET AL: "Low-noise amplifier cryogenic testbed validation in a TaaS (Testing-as-a-Service) framework", ARXIV.ORG, CORNELL UNIVERSITY LIBRARY, 201 OLIN LIBRARY CORNELL UNIVERSITY ITHACA, NY 14853, 7 September 2023 (2023-09-07), XP091608202, * paragraphs [0III] - [III.B], [00II]; figures 4a, 4b * | 1-10 | INV. G01R27/32 G01R35/00 |
| A | SIMBIEROWICZ SLAWOMIR ET AL: "Characterizing cryogenic amplifiers with a matched temperature-variable noise source", REVIEW OF SCIENTIFIC INSTRUMENTS, AMERICAN INSTITUTE OF PHYSICS, 2 HUNTINGTON QUADRANGLE, MELVILLE, NY 11747, vol. 92, no. 3, 11 March 2021 (2021-03-11), XP012254685, ISSN: 0034-6748, DOI: 10.1063/5.0028951 [retrieved on 2021-03-11] * paragraphs [II.A] - [II.B], [AppendixB]; figures 2, 6 * | 1-10 | |
| A | RANZANI LEONARDO ET AL: "Two-port microwave calibration at millikelvin temperatures", REVIEW OF SCIENTIFIC INSTRUMENTS, AMERICAN INSTITUTE OF PHYSICS, 2 HUNTINGTON QUADRANGLE, MELVILLE, NY 11747, vol. 84, no. 3, 1 March 2013 (2013-03-01), pages 34704-34704, XP012174672, ISSN: 0034-6748, DOI: 10.1063/1.4794910 [retrieved on 2013-03-15] * paragraphs [0083] - [0114]; figures 1-7 * | 1-10 | |

TECHNICAL FIELDS SEARCHED (IPC)

G01R

-----

-----

-/--

The present search report has been drawn up for all claims

| Place of search | Date of completion of the search | Examiner |
|---|---|---|
| Munich | 3 June 2025 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 22 0622

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2024/192300 A1 (BRESSER GERD [DE] ET AL) 13 June 2024 (2024-06-13) <br> * paragraphs [00II] - [II.A]; figure 1a * <br> ----- | 1-10 | |
| | | | **TECHNICAL FIELDS SEARCHED (IPC)** |

The present search report has been drawn up for all claims

| Place of search | Date of completion of the search | Examiner |
|---|---|---|
| Munich | 3 June 2025 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 22 0622

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2025

| Patent document cited in search report | Publication date | Patent family member(s) | | Publication date |
|---|---|---|---|---|
| US 2024192300 A1 | 13-06-2024 | CN | 118175078 A | 11-06-2024 |
| | | EP | 4382923 A1 | 12-06-2024 |
| | | US | 2024192300 A1 | 13-06-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SIMBIEROWICZ et al.** Characterizing cryogenic amplifiers with a matched temperature-variable noise source. *Review of Scientific Instruments*, vol. 92 (3), 034708, https://doi.org/10.1063/5.0028951